# FASCICULE DE BREVET EUROPEEN

(11) **EP 1 803 031 B1**
(45) Date de publication et mention de la délivrance du brevet: **02.01.2008**
(21) Numéro de dépôt: 05815864.3
(22) Date de dépôt: 19.10.2005
(51) Int. Cl.: G03F 1/14

(54) **MASQUE DE LITHOGRAPHIE REFLECHISSANT ET PROCEDE DE FABRICATION ASSOCIE**
REFLEKTIERENDE LITHOGRAPHIEMASKE UND VERFAHREN ZU DEREN HERSTELLUNG
REFLECTIVE LITHOGRAPHIC MASK AND MANUFACTURING METHOD THEREOF

(30) Priorité: 19.10.2004 FR 0411073
(43) Date de publication de la demande: 04.07.2007
(73) Titulaire: COMMISSARIAT A L'ENERGIE ATOMIQUE, 75015 Paris (FR)
(72) Inventeur: CHARPIN-NICOLLE, Christelle, F-38120 FONTANIL-CORNILLON (FR); ROBIC, Jean-Yves, F-38100 GRENOBLE (FR)
(74) Mandataire: Poulin, Gérard
(86) Numéro de dépôt international: PCT/FR2005/050868
(87) Numéro de publication internationale: WO 2006/043004

(56) Documents cités:
- WO-A-03/085709
- US-A- 4 110 815
- US-A1- 2003 228 530
- US-A1- 2004 125 649

## Description

### DOMAINE TECHNIQUE

L'invention concerne une structure pour masque de lithographie en réflexion, en particulier pour la lithographie extrême ultra violet (EUV). L'invention concerne également un procédé de fabrication de ce masque.

Un tel masque est utilisable notamment pour la lithographie en réflexion, en particulier pour la lithographie Extrême UV. L'invention concerne plus spécifiquement l'empilement absorbant utilisé dans les masques EUV.

### ÉTAT DE LA TECHNIQUE ANTÉRIEURE

La lithographie, ou photolithographie, est le procédé qui permet de transférer l'image d'un masque dans une couche de résine photosensible déposée sur un échantillon. Cette étape d'insolation d'une résine au travers d'un masque, à l'aide d'une source de lumière et d'un système optique, est réalisée sur un équipement dénommé photo-répéteur. Après insolation, la résine est révélée, permettant ainsi d'obtenir sur l'échantillon un masque de résine qui servira pour les étapes nécessaires à la réalisation de dispositif microélectronique (masque servant à la gravure, masque servant au dépôt ou masque servant à l'implantation ionique).

Les progrès de la lithographie optique ont été un facteur-clé de la croissance de l'industrie des circuits intégrés (CI) toutes ces dernières années. Le principal facteur d'amélioration est l'utilisation d'une longueur d'onde de plus en plus courte pour l'insolation des résines. Ainsi, les longueurs d'ondes utilisées en lithographie sont passées de 365 nanomètres à 248 nanomètres et aujourd'hui à 193 nanomètres.

La diminution de la longueur d'onde permet de réduire les dimensions critiques des circuits intégrés jusqu'à atteindre des dimensions des circuits intégrés de l'ordre du dixième de micromètre. Ces progrès techniques et la disponibilité, à temps, des équipements de production pour la photolithographie, des masques et des résines ont permis, depuis 30 ans, à l'industrie de la microélectronique de poursuivre sa croissance.

Cependant, la poursuite de la miniaturisation des circuits intégrés avec des motifs inférieurs à 0,1 micromètre nécessite une nouvelle approche technologique en rupture avec la lithographie optique. En effet, les matériaux réfractifs couramment utilisés pour la lithographie optique deviennent trop absorbants pour des longueurs d'onde inférieures à 190 nanomètres.

Différentes solutions regroupées sous le nom de NGL ou lithographie de nouvelle génération (en anglais New Generation Lithography) ont été proposées. L'enjeu est capital pour l'industrie des semiconducteurs. Parmi les lithographies de nouvelle génération, la lithographie Extrême Ultra-Violet (EUV), utilisant des longueurs d'onde comprises entre 10 et 14 nm (rayonnement X mou), est une des voies les plus prometteuses. A ces courtes longueurs d'onde, une résolution inférieure à 0,1 micromètre peut être obtenue, tout en gardant une ouverture numérique faible et une profondeur de champ supérieure à un micromètre. Cette technologie peut satisfaire plusieurs générations technologiques sub-0,1 micromètre jusqu'à la génération 256 Gbit prévue en production en 2012 par la Semiconductor Industry Association (SIA).

La lithographie EUV est une des solutions choisies. Des travaux importants sont en cours à ce sujet aux Etats-Unis, au Japon et en Europe. Les défis technologiques posés par la mise en oeuvre d'une lithographie dans l'extrême UV concerne particulièrement cinq aspects : la source de rayonnement EUV, l'optique de projection du photo-masqueur, les masques, les procédés utilisant des résines et la métrologie associée au développement des optiques et des masques.

Contrairement aux masques actuels de lithographie optique (masques en transmission réalisés par un dépôt de chrome sur un support en quartz), un masque pour la lithographie EUV est un masque en réflexion et non plus en transmission.

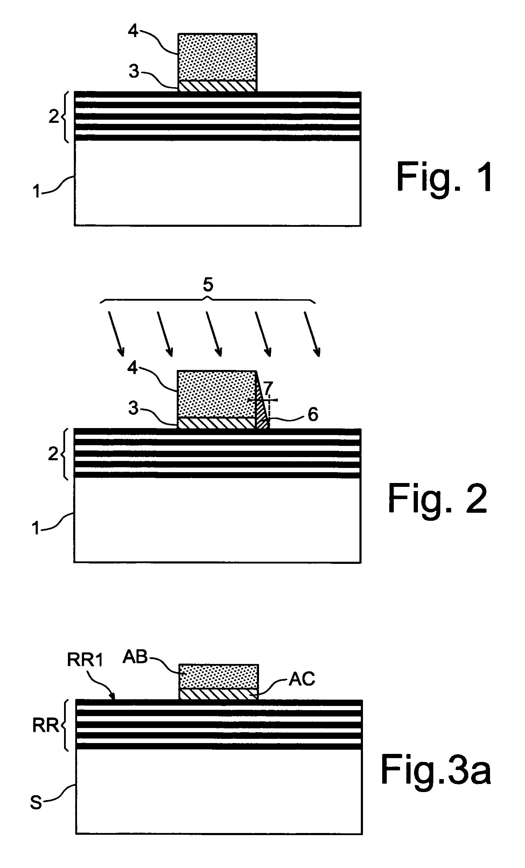

La figure 1 est une vue en coupe transversale d'un masque EUV selon l'art connu. Ce masque se compose d'un substrat 1 sur lequel est déposé un revêtement réflecteur 2 qui est à son tour recouvert d'une couche absorbante 4. Le motif à projeter sur la résine à insoler est formé sur le masque par gravure de la couche absorbante 4. Ainsi, seules les zones gravées seront réfléchissantes et viendront s'inscrire lors de la projection lithographique. On peut prévoir, comme cela est illustré sur la figure 1, entre la couche absorbante 4 et le revêtement réflecteur 2, une couche 3 servant de couche barrière à la gravure de la couche absorbante si la sélectivité de gravure entre la couche absorbante et le revêtement réflecteur n'est pas suffisante. Cette couche 3 participe également à l'absorption.

Le substrat 1 peut être une plaquette de silicium de 200 mm de diamètre. D'autres substrats peuvent être envisagés afin de tenir compte des problèmes de stabilité sous flux lumineux, par exemple un verre à faible coefficient de dilatation.

Le réflecteur 2 est constitué d'un empilement de multicouches. Un grand facteur de réflexion est obtenu à l'aide d'une structure interférentielle de multicouches et par le bon choix des matériaux constituant les multicouches. Le molybdène et le silicium offrent de bonnes performances à la longueur d'onde de 13 nanomètres et des facteurs de réflexion supérieurs à 65% peuvent être obtenus avec environ une quarantaine de multicouches. Chaque multicouche est formée d'une couche de molybdène et d'une couche de silicium. D'autres couches de matériaux sont envisageables comme par exemple Mo/Be ou encore Ru/Be.

La couche absorbante 4 doit être absorbante dans la gamme spectrale de l'EUV, notamment autour de 13 nanomètres. Les matériaux utilisables pour la constituer sont nombreux. Les matériaux utilisés en microélectronique (comme Ti, Ta, TaSi, TiW, W, Cr, TiN, Al) sont préférés.

Pour une optique ayant un facteur de réduction de 4, la taille du motif gravé dans la couche absorbante sera quatre fois plus grande que le motif insolé sur le circuit. On parle de réticule à l'échelle 4X. Pour tenir les spécifications liées à l'étape d'insolation, c'est-à-dire imprimer sur la résine insolée un motif de bonne définition géométrique, conservant les dimensions souhaitées sur toute la zone insolée et sans défauts, la réalisation du masque doit répondre à certaines conditions:
- Le masque doit posséder une certaine planéité, avec uniquement des valeurs de déformations inférieures à 0,4 micromètre pour un diamètre de 200 mm.
- Le coefficient de réflexion du masque doit être suffisant pour garantir la dose de rayonnement EUV nécessaire à l'insolation, soit un coefficient de réflexion supérieur à 60%.
- La couche absorbante doit être réalisée (dépôt et gravure) conformément à la géométrie souhaitée.
- Le taux de défauts en surface du masque doit être extrêmement faible, de l'ordre de quelques 10⁻³ défauts/cm2, pour des défauts de dimensions égales ou supérieures à 50 nanomètres environ.
- La multicouche et la couche absorbante qui constituent le masque sont situés au plan objet du système optique. En conséquence, toute variation significative de phase ou d'amplitude du champ réfléchi par le masque peut potentiellement être répliqué par le procédé de lithographie et peut ainsi imprimer un défaut rédhibitoire dans la résine. S'il existe des procédés pour réparer les défauts de la couche absorbante, il n'existe pas de solution satisfaisante pour réparer les défauts dans la multicouche réflectrice. Cette dernière condition reste le problème majeur pour la maîtrise de la réalisation des masques. Les meilleurs résultats obtenus sont de quelques centièmes de défaut/cm².

Les spécifications des masques, en terme de contrôle et de défauts, impliquent la maîtrise technologique de toutes les étapes de réalisation de celui-ci. L'élaboration des masques se fait en deux grandes étapes :
- la réalisation du substrat réflecteur multicouche appelé "blank mask" dans la littérature spécialisée anglo-saxonne.
- la réalisation du réticule (appelé "mask patterning" en anglais), c'est-à-dire la réalisation des motifs absorbants sur le réflecteur multicouche.

De nombreux matériaux ont été proposés pour réaliser l'empilement absorbant. Les matériaux absorbants trouvés dans la littérature sont la plupart du temps des matériaux métalliques, tels le Ti, Ta, TaSi, TiW, W, Cr, TiN, Cr, Ru. On peut également trouver des matériaux non métalliques tels le Ge.

Il est nécessaire de prévoir la couche tampon 3 (figures 1 et 2) pour les raisons suivantes:
- Maîtriser l'arrêt de gravure (ne pas abimer le miroir)
- Réaliser une inspection en lumière Deep UV (par exemple 257 nanomètres) pour voir les défauts et éventuellement les corriger.

Par ailleurs, il convient de ne pas abimer le revêtement réflecteur, et pour cela, il convient de:
- ne pas détériorer les couches supérieures au cours des étapes technologiques,
- ne pas dépasser 150°C au cours des étapes technologiques, sinon on a un risque de perte de réflectivité du masque (réflectivité voulue supérieure à 67%).

En ce qui concerne l'élément absorbant 4, il doit permettre d'obtenir un bon pouvoir absorbant de l'empilement absorbant (couche 3 et couche 4) dans l'Extrême UV, soit une réflectivité moyenne de l'empilement absorbeur inférieure à 0,5%.

On doit avoir une réflectivité faible en insolation DUV de l'empilement absorbant (à une longueur d'onde comprise entre 120 nanomètres et 257 nanomètres) : réflectivité inférieure à 20% (classe D), voire réflectivité inférieure à 5% (classe A).

En ce qui concerne les états de surfaces, on doit avoir un taux de défauts extrêmement faible sur le miroir: de l'ordre de quelques millièmes de défaut/cm² pour des défauts de dimensions égales ou supérieures à 50 nanomètres environ.

On doit avoir peu de rugosités sur les parois de l'empilement d'absorbant.

Par ailleurs, comme cela est représenté sur la figure 2, l'élément absorbant produit une zone d'ombre 6 de dimension 7 sur la surface du revêtement réflecteur lors de l'éclairement du masque par un rayonnement 5. Pour minimiser les effets d'ombrage liés à l'angle d'incidence du faisceau extrême UV sur le masque (même pour un angle d'incidence faible, généralement 5 à 6° et parfois un peu moins), on a intérêt à diminuer l'épaisseur de l'empilement absorbant, d'autant que cet effet d'ombrage est d'autant plus marqué et gênant que les motifs à insoler sont petits.

### EXPOSÉ DE L'INVENTION

L'invention a pour objet de réduire ces effets d'ombrage dus à la couche d'absorbant.

Elle a également pour objet de fournir une alternative aux matériaux traditionnellement utilisés comme absorbeur.

On connaît déjà par le document (1) US 2003/0228530 A, un masque EUV comportant un absorbeur amélioré ; mais ce document ne divulgue pas l'utilisation d'une couche absorbante uniquement en matériau diélectrique : il enseigne l'utilisation d'un absorbeur comprenant un métal et un diélectrique.

On connaît aussi, par le document (2) WO 03/085709 A (voir aussi EP 1498936 A), un masque EUV comprenant une couche absorbante en TaBN, TaBNO ou TaBO.

De façon précise, l'invention a pour objet un masque de lithographie par réflexion comprenant, sur un substrat, un revêtement réflecteur et un empilement constitué d'une couche d'arrêt à la gravure et d'une couche absorbante, l'empilement recouvrant une partie seulement du revêtement réflecteur, caractérisé en ce que la couche absorbante est réalisée uniquement en matériau diélectrique contenant de l'Hafnium Hf et constitue la couche de surface du masque.

Ledit matériau diélectrique est absorbant de préférence dans la gamme des longueurs d'onde des rayonnements Extrêmes Ultra Violets.

Selon une forme de réalisation préférée de l'invention, le matériau diélectrique peut être sous forme d'un oxyde d'Hafnium HfO₂.

De préférence, les épaisseurs respectives de la couche absorbante et de la couche d'arrêt à la gravure sont choisies de sorte que l'empilement de ces couches forme un système interférentiel présentant une bonne absoption dans le domaine EUV et un bon contraste en réflectivité dans le domaine DUV-visible lors d'une étape d'inspection de la gravure de la couche absorbante.

De préférence, les matériaux de la couche absorbante et de la couche d'arrêt à la gravure sont choisis de façon qu'ils présentent une bonne sélectivité à la gravure et que la couche d'arrêt à la gravure présente une bonne sélectivité de gravure vis-à-vis du revêtement réflecteur.

La couche d'arrêt à la gravure peut être en un matériau diélectrique.

Le matériau diélectrique de la couche absorbante étant un oxyde d'Hafnium HfO₂, la couche d'arrêt à la gravure peut être en oxyde d'aluminium Al₂O₃.

De préférence, les épaisseurs de HfO₂ et de Al₂O₃ sont respectivement égales à 40 nm et à 20nm.

L'invention concerne également un procédé de fabrication d'un masque tel que décrit précédemment. Ce procédé comporte les étapes suivantes:
- Etape 1: Dépôt, sur un substrat, d'une alternance de couches réflectrices d'indices optiques différents, formant un système interférentiel.
- Etape 2: Dépôt d'une couche d'arrêt à la gravure sur ladite alternance de couches.
- Etape 3: Dépôt d'une couche dudit matériau diélectrique en vue de réaliser la couche absorbante.
- Etape 4: Etalement d'une résine de lithographie.
- Etape 5: Réalisation, dans la résine, d'un motif ayant la forme de la couche absorbante à obtenir.
- Etape 6: Gravure, de préférence chimique, de la couche de matériau diélectrique.
- Etape 7: retrait de la résine, de préférence constitué d'un retrait à sec de la résine suivi d'un retrait humide.
- Etape 8: gravure de la couche d'arrêt à la gravure.

Le matériau diélectrique est avantageusement du HfO2 et l'étape 3 peut être réalisée par pulvérisation par faisceau d'ions (en anglais : ion beam sputtering) à une température d'environ 50°C.

De préférence, le procédé comprend en outre une étape d'inspection de la gravure de la couche absorbante avant le retrait de la couche d'arrêt de gravure.

L'inspection est de préférence effectuée au moyen d'un rayonnement dont la longueur d'onde appartient au domaine allant du domaine visible au domaine ultraviolet profond DUV.

De plus, on peut effectuer une gravure complémentaire, par exemple localisée, de la couche absorbante afin de permettre une bonne gravure de la couche absorbante sans endommager la multicouche réflectrice contituée de l'alternance des couches réflectrices, cette multicouche réflectrice étant protégée par la couche d'arrêt à la gravure.

### BRÈVE DESCRIPTION DES DESSINS

Les différents objets et caractéristiques de l'invention apparaîtront plus clairement dans la description qui va suivre ainsi que dans les figures annexées sur lesquelles:
- les figures 1 et 2 représentent un masque de lithographie par réflexion connu dans la technique et ont déjà été décrites,
- les figures 3a et 3b représentent des exemples de réalisation de masques selon l'invention, et
- les figures 4a à 4h représentent différentes étapes d'un exemple de réalisation d'un procédé de fabrication d'un masque selon l'invention.

### EXPOSÉ DÉTAILLÉ DE MODES DE RÉALISATION PARTICULIERS

En se reportant à la figure 3a, on va donc décrire un exemple de réalisation d'un masque selon l'invention. Ce masque comporte, sur un substrat S, un revêtement réflecteur RR qui est typiquement un empilement de couches de matériaux d'indices optiques différents de telle façon que cet empilement de couches se comporte comme un miroir de Bragg pour un rayonnement incident à une longueur d'onde d'utilisation en lithographie. Cet empilement de couches peut être une alternance de couches de molybdène et de silicium.

Une couche AB en matériau absorbant est situé sur la surface RR1 du revêtement réflecteur. Entre la couche AB et la surface RR1 est prévue une couche d'arrêt de gravure AC dont le rôle est de protéger la surface RR1 lors de la gravure de la couche AB pour définir son contour. Il convient de noter que la couche AB constitue la couche de surface du masque :
la couche AC est entre la couche AB et le revêtement RR.

Selon l'invention, la couche AB est entièrement en matériau diélectrique contenant de l'Hafnium et notamment un diélectrique à moyenne ou haute permittivité.

Le matériau diélectrique est absorbant dans la gamme des longueurs d'ondes des rayonnements Extrêmes UV pour une utilisation dans cette gamme de longueurs d'onde.

Le matériau absorbant peut être avantageusement un matériau diélectrique contenant de l'oxyde d'Hafnium HfO₂.

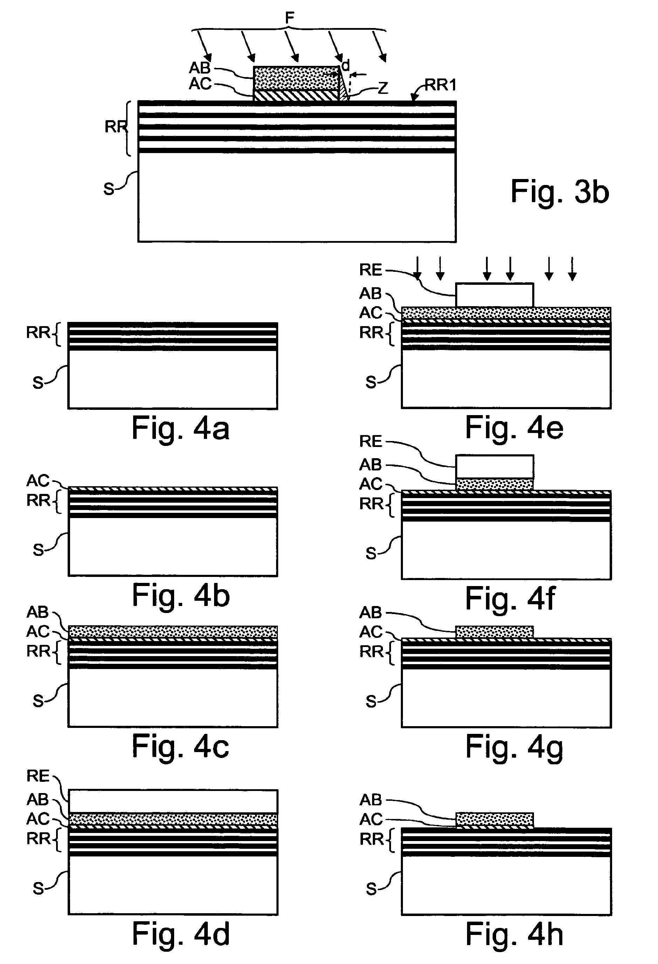

L'utilisation d'oxyde d'Hafnium HfO₂ permet de réduire l'épaisseur de l'élément car il présente un très bon coefficient d'absorption dans le domaine EUV. Ainsi, lors de l'utilisation du masque dans une opération de lithographie par réflexion, le masque éclairé par un faisceau F (figure 3b) donnera une zone d'ombre Z qui produira une ombre portée sur la surface RR1 de dimension d. Cette dimension de cette ombre portée sera plus petite que la dimension 7 de l'ombre faite par l'élément absorbant de la figure 2.

L'utilisation d'oxyde d'Hafnium HfO₂ dans la couche absorbante permet ainsi de réduire les effets d'ombrage sur la surface du revêtement réflecteur du masque.

La couche d'arrêt d'attaque de gravure peut être alors de l'oxyde d'aluminium Al₂O₃. Ce pourrait être également un empilement de plusieurs couches, par exemple des couches de chrome et d'Al₂O₃.

Dans le cas particulier d'un empilement HfO₂/Al₂O₃, on pourra prévoir une couche de diélectrique HfO₂ de 40 nanomètres d'épaisseur et une couche d'arrêt d'attaque de gravure Al₂O₃ d'épaisseur 20 nanomètres. On aura alors un empilement d'une épaisseur totale de 60 nanomètres. Ces épaisseurs sont bien plus faibles que celles couramment connues dans la technique (typiquement de l'ordre de 120 nanomètres).

En se reportant aux figures 4a à 4h, nous allons décrire un exemple de réalisation d'un procédé de fabrication d'un masque selon l'invention tel que décrit précédemment. Ce procédé comporte les étapes suivantes:
- Etape 1: Dépôt par IBS ou pulvérisation par faisceau d'ions (en anglais :Ion Beam Sputtering), sur un substrat S, de 40 paires de couches Molybdène/Silicium. L'alternance de couches présente une période 6,95 nm. On obtient ainsi le revêtement réflecteur RR (figure 4a).
- Etape 2: Dépôt d'une couche de Al₂O₃ de 20 nanomètres d'épaisseur par un procédé de dépôt ALCVD ou dépôt chimique de couches atomiques en phase vapeur (en anglais :Atomic Layer Chemical Vapor Déposition) à 120°C. On réalise ainsi la couche d'arrêt de gravure AC (figure 4b). Dans notre exemple, il s'agit d'une couche d'arrêt à la gravure par plasma.
- Etape 3: Dépôt d'une couche de Hf0₂ de 40 nanomètres d'épaisseur à 50°C par IBS, c'est-à-dire par pulvérisation par faisceau d'ions (en anglais :Ion Beam Sputtering), en vue de réaliser la couche absorbante AB (figure 4c).
- Etape 4: . Etalement d'une résine de lithographie telle que la résine UV5 commercialisée par Rhom & Haas Electronics Materials (RHEM) (figure 4d).
- Etape 5: Réalisation, par lithographie UV (à 248 nm) ou faisceau d'électrons par exemple, dans la résine, d'un motif ayant la forme de la couche absorbante à obtenir (figure 4e).
- Etape 6: Gravure, par plasma par exemple, de l'oxyde d'Hafnium HfO₂ à une température de l'ordre de 100°C, par exemple avec le mélange gazeux Cl₂, HBr et O₂. Puis par exemple nettoyage au HF (acide fluorhydrique) 1% (figure 4f).
   D'autres types de gravures pourront, bien sûr, être choisis en fonction du diélectrique à graver.
- Etape 7: Enlèvement de la résine (figure 4g), par exemple, en deux étapes: retrait à sec (stripping) suivi d'un retrait humide (par exemple par traitement EKC 265, le produit EKC 265 étant commercialisé par la Société EKC).
   Le procédé utilisé pour le stripping sec est un procédé à base d'argon, d'oxygène et de CF₄.
   La température atteinte lors du stripping sec est comprise entre 54°C et 60°C. Elle a été vérifiée à l'aide de "stickers". Les stickers sont des indicateurs constitués de différents polymères qui changent de couleur lorsque la température sur la plaque dépasse leur température de transition vitreuse Tg.
   Le stripping humide est réalisé avec une solution chimique EKC 265. La température maximale atteinte lors du stripping humide est comprise entre 65°C et 70°C (vérification réalisée à l'aide de stickers).
- Etape 8: Gravure de la couche d'arrêt dans les zones gravées de la couche de Hf0₂ pour mettre à nu localement le revêtement réflecteur (figure 4h).

Cette étape peut être, par exemple dans le cas d'une couche d'arrêt en Al₂O₃, une gravure chimique HF 1%.

Le masque ainsi réalisé a fait l'objet d'essais et de simulations.
- Il apparaît que l'indice d'absorption dans l'EUV (à 13,5 nm) du HfO₂ est de 0,0465 et est meilleur que ceux de matériaux utilisés tel que le TaN qui à un indice d'absorption de 0,044 et le chrome qui a un indice de 0,0383.
- Par simulation, la réflectivité de l'empilement du HfO₂ et de la couche de Al₂O₃ (40 nm de HfO₂ et 20nm de Al₂O₃) a été trouvée inférieure à 0,5% pour un éclairement dans l'EUV (à 13,5 nm).
- Egalement par simulation, la réflectivité de cet empilement a été trouvée de l'ordre de 1,9% à une longueur d'onde de 248 nm et de 2,9% à une longueur d'onde de 257 nm.

On voit donc que le masque de l'invention donne satisfaction avec une épaisseur d'absorbant nettement inférieure aux dispositifs connus. Citons à titre d'exemple le masque tel que décrit dans le document

"Cr Absorber Mask for Extreme Ultraviolet Lithography" de Guojing Zhang et al, Proc. of SPIE, vol 4186 (2001) p 774-780.
et comportant une couche d'absorbant à base de chrome et une couche tampon de SiO₂ qui nécessite 70 nm de chrome et 90 nm de SiO₂, ce qui fait une hauteur de l'élément absorbant de 160 nm.

En revenant à l'exemple du procédé que l'on a donné plus haut, on précise qu'il est préférable d'inspecter la gravure de la couche absorbante avant de retirer la couche d'arrêt de gravure. Cette inspection est effectuée de préférence avec un rayonnement dont la longueur d'onde se situe dans le domaine allant du domaine visible au domaine DUV.

Il est en outre possible de faire une étape complémentaire de réparation de la couche absorbante (étape appelée « repair »), cette étape étant par exemple une gravure localisée de la couche absorbante ou un dépôt localisé sur la couche absorbante, de façon à définir de façon très précise la géométrie finale du masque. Cette étape de « repair » doit être faite sans endommager le revêtement réflecteur RR protégé par la couche d'arrêt de gravure AC.

On précise de plus que, dans l'invention, les matériaux et les épaisseurs respectives de la couche absorbante et de la couche d'arrêt sont choisis de sorte que l'empilement de ces couches forme un système interférentiel présentant une bonne absorption dans le domaine EUV et, une fois gravée la couche absorbante, un bon contraste en réflectivité dans le domaine DUV-visible entre les zones gravées et non gravées (afin d'effectuer l'étape d'inspection mentionnée ci-dessus).

Ces couches doivent par ailleurs présenter une bonne sélectivité à la gravure afin que la couche absorbante puisse être gravée sans endommager la multicouche réflectrice. De même, la couche d'arrêt doit présenter une bonne sélectivité de gravure par rapport à la multicouche réflectrice afin qu'elle puisse être éliminée sans endommager cette multicouche.

Le couple HfO₂/Al₂O₃ est particulièrement intéressant : il remplit ces différents critères.

Le fait d'utiliser deux matériaux diélectriques pour la couche absorbante et la couche d'arrêt est avantageux. En effet, ces matériaux sont transparents pour les longueurs d'ondes utilisées pour l'inspection (domaine DUV-visible), ce qui permet d'optimiser les critères précédemment définis avec des épaisseurs minimales pour ces couches.

Les résultats de simulations ont été donnés précédemment pour un empilement de 40nm de HfO₂ et 20nm d'Al₂O₃, soit 60nm au total. Cet empilement a montré de très bonnes qualités optiques et ce pour une épaisseur très faible, limitant ainsi entre autres les effets d'ombrage.

## Revendications

1. Masque de lithographie par réflexion comprenant, sur un substrat (S), un revêtement réflecteur (RR) et un empilement constitué d'une couche d'arrêt à la gravure (AC) et d'une couche absorbante (AB), l'empilement recouvrant une partie seulement du revêtement réflecteur, **caractérisé en ce que** la couche absorbante est réalisée uniquement en matériau diélectrique contenant de l'Hafnium Hf et constitue la couche de surface du masque.

2. Masque selon la revendication 1, dans lequel ledit matériau diélectrique est absorbant dans la gamme des longueurs d'onde des rayonnements Extrêmes Ultra Violets.

3. Masque selon l'une quelconque des revendications 1 et 2, dans lequel le matériau diélectrique est un oxyde d'Hafnium HfO₂.

4. Masque selon l'une quelconque des revendications 1 à 3, dans lequel les épaisseurs respectives de la couche absorbante et de la couche d'arrêt à la gravure sont choisies de sorte que l'empilement de ces couches forme un système interférentiel présentant une bonne absorption dans le domaine EUV et un bon contraste en réflectivité dans le domaine DUV-visible lors d'une étape d'inspection de la gravure de la couche absorbante.

5. Masque selon l'une quelconque des revendications 1 à 4, dans lequel les matériaux de la couche absorbante et de la couche d'arrêt à la gravure sont choisis de façon qu'ils présentent une bonne sélectivité à la gravure et que la couche d'arrêt à la gravure présente une bonne sélectivité de gravure vis-à-vis du revêtement réflecteur.

6. Masque selon l'une quelconque des revendications 1 à 5, dans lequel la couche d'arrêt à la gravure est en un matériau diélectrique.

7. Masque selon l'une quelconque des revendications 1 à 4, dans lequel le matériau diélectrique de la couche absorbante est un oxyde d'Hafnium HfO₂ et la couche d'arrêt à la gravure est en oxyde d'aluminium Al₂O₃.

8. Masque selon la revendication 7 dans lequel les épaisseurs de HfO₂ et de Al₂O₃ sont respectivement égales à 40nm et 20nm.

9. Procédé de fabrication d'un masque selon l'une quelconque des revendications précédentes, comportant les étapes suivantes:
a. Etape 1: dépôt, sur un substrat (S), d'une alternance de couches réflectrices d'indices optiques différents, formant un système interférentiel.
b. Etape 2: dépôt d'une couche d'arrêt à la gravure sur ladite alternance de couches.
c. Etape 3: dépôt d'une couche d'un matériau diélectrique en vue de réaliser la couche absorbante.
d. Etape 4: étalement d'une résine de lithographie.
e. Etape 5: réalisation, dans la résine, d'un motif ayant la forme de la couche absorbante à obtenir.
f. Etape 6: gravure de la couche de matériau diélectrique.
g. Etape 7: retrait de la résine.
h. Etape 8: gravure de la couche d'arrêt à la gravure.

10. Procédé de fabrication d'un masque selon la revendication 9, dans lequel le matériau diélectrique est du HfO₂.

11. Procédé de fabrication selon la revendication 12, dans lequel l'étape 3 est réalisée par pulvérisation par faisceau d'ions à une température d'environ 50°C.

12. Procédé selon l'une quelconque des revendications 9 à 11, comprenant en outre une étape d'inspection de la gravure de la couche absorbante avant le retrait de la couche d'arrêt de gravure.

13. Procédé selon la revendication 12, dans lequel l'inspection est effectuée au moyen d'un rayonnement dont la longueur d'onde appartient au domaine allant du domaine visible au domaine ultraviolet profond DUV.

14. Procédé selon l'une quelconque des revendications 9 à 13, dans lequel on effectue une gravure complémentaire de la couche absorbante afin de permettre une bonne gravure de la couche absorbante sans endommager la multicouche réflectrice constituée de l'alternance des couches réflectrices, cette multicouche réflectrice étant protégée par la couche d'arrêt à la gravure.

15. Procédé selon la revendication 14, dans lequel la gravure complémentaire est localisée.

## Claims

1. A reflection lithography mask comprising, on a substrate (S), a reflector coating (RC) and a stack comprised of an etching barrier layer (AC) and an absorbing layer (AB), said stack covering only a part of the reflector coating, **characterized in that** the absorbing layer is made solely of dielectric material containing hafnium Hf and constitutes the surface layer of the mask.

2. A mask according to claim 1, wherein the aforementioned dielectric material is absorbent in the extreme ultraviolet (EUV) radiation wavelength range.

3. A mask according to claim 1 and 2, wherein the dielectric material is a random hafnium oxide HfO₂.

4. A mask according to any one of the claims 1 to 3, wherein the respective thicknesses of the absorbing layer and the etching barrier layer are selected in such a way that the stack of said layers forms an interference system exhibiting good absorption in the EUV range and good reflectivity contrast in the DUV-visible range during a step of inspection of the etching of the absorbing layer.

5. A mask according to any of the claims 1 to 4, wherein the materials of the absorbing layer and the etching barrier layer are selected in such a way that they have good etch selectivity and that the etching barrier layer has good etch selectivity with respect to the reflector coating.

6. A mask according to any of the claims 1 to 5, wherein the etching barrier layer is made of a dielectric material.

7. A mask according to any of the claims 1 to 4, wherein the dielectric material of the absorbing layer is made of hafnium oxide (HfO₂) and the etching barrier layer is made of aluminium oxide (Al₂O₃).

8. A mask according to claim 7, wherein the thicknesses of HfO₂ and Al₂O₃ are equal to 40 nm and 20 nm, respectively.

9. A method for manufacturing a mask according to any of the preceding claims, comprising the following steps:
a. Step 1: deposition, on a substrate (S), of alternating reflecting layers of different optical indices, forming an interference system.
b. Step 2: deposition of an etching barrier layer on the aforementioned alternating layers.
c. Step 3: deposition of a layer of a dielectric material for the purpose of producing the absorbing layer.
d. Step 4: spreading of a lithography resin.
e. Step 5: production, in the resin, of a pattern having the shape of the absorbing layer to be obtained.
f. Step 6: etching of the layer of dielectric material.
g. Step 7: stripping of the resin.
h. Step 8: etching of the etching barrier layer.

10. A method for manufacturing a mask according to claim 9, wherein the dielectric material is HfO₂.

11. A manufacturing method according to claim 9, wherein step 3 is carried out by ion beam sputtering at a temperature of approximately 50°C.

12. A method according to any of the claims 9 to 11, comprising in addition a step of inspection of the etching of the absorbing layer before the stripping of the etching barrier layer.

13. A method according to claim 12, wherein the inspection is carried out by means of radiation having a wavelength in the visible to deep ultraviolet (DUV) range.

14. A method according to any of the claims 9 to 13, wherein complementary etching of the absorbing layer is performed in order to allow good etching of the absorbing layer without damaging the reflective multilayer comprised of the alternating reflecting layers, said reflective multilayer being protected y the etching barrier layer.

15. A method according to claim 14, wherein the complementary etching is localized.

## Patentansprüche

1. Reflektierende Lithographiemaske mit - auf einem Substrat S - einer reflektierenden Beschichtung (RR) und einem Stapel, gebildet durch eine Ätzsperrschicht (AC) und eine Absorptionsschicht (AB), wobei der Stapel nur einen Teil der reflektierenden Beschichtung bedeckt,
**dadurch gekennzeichnet, dass** die Absorptionsschicht nur aus dielektrischem, Hafnium Hf enthaltendem Material ist und die Oberflächenschicht der Maske bildet.

2. Maske nach Anspruch 1, bei der das genannte dielektrische Material in dem Bereich der Wellenlängen der Extrem-UV-Strahlen absorbiert.

3. Maske nach einem der Ansprüche 1 und 2, bei der das dielektrische Material ein Hafniumoxid HfO₂ ist.

4. Maske nach einem der Ansprüche 1 bis 3, bei der die jeweiligen Dicken der Absorptionsschicht und der Ätzsperrschicht so gewählt werden, dass der Stapel aus diesen Schichten ein Interferenzsystem bildet, das im EUV-Bereich gut absorbiert und in dem DUV-VIS-Bereich einen guten Reflektivitätskontrast gewährleistet, bei einem Kontrollschritt der Ätzung der Absorptionsschicht.

5. Maske nach einem der Ansprüche 1 bis 4, bei der die Materialien der Absorptionsschicht und der Ätzsperrschicht so gewählt werden, dass sie eine gute Ätzselektivität aufweisen und dass die Ätzsperrschicht eine gute Ätzselektivität gegenüber der reflektierenden Beschichtung aufweist.

6. Maske nach einem der Ansprüche 1 bis 5, bei der die Ätzsperrschicht aus einem dielektrischen Material ist.

7. Maske nach einem der Ansprüche 1 bis 4, bei der das dielektrische Material der Absorptionsschicht ein Hafniumoxid HfO₂ ist und die Ätzsperrschicht aus Aluminiumoxid Al₂O₃ ist.

8. Maske nach Anspruch 7, bei der die Dicken von HfO₂ und von Al₂O₃ jeweils gleich 40 nm und 20 nm sind.

9. Verfahren zur Herstellung einer Maske nach einem der vorangehenden Ansprüche, die folgenden Schritte umfassend:
a. Schritt 1: Abscheiden einer Wechselfolge von ein Interferenzsystem bildenden reflektierenden Schichten mit unterschiedlichen Brechzahlen auf einem Substrat (S).
b. Schritt 2: Abscheiden einer Ätzsperrschicht auf der genannten Schichten-Wechselfolge.
c. Schritt 3: Abscheiden einer Schicht aus einem dielektrischen Material hinsichtlich der Realisierung der Absorptionsschicht.
d. Schritt 4: Ausbreiten eines Lithographie-Resists.
e. Schritt 5: Realisieren eines Musters mit der Form der herzustellenden Absorptionsschicht in dem Resist.
f. Schritt 6: Ätzen der Schicht aus dielektrischem Material.
g. Schritt 7: Entfernen des Resists.
h. Schritt 8: Ätzen der Ätzsperrschicht.

10. Herstellungsverfahren einer Maske nach Anspruch 9, bei dem das dielektrische Material HfO₂ ist.

11. Herstellungsverfahren nach Anspruch 9, bei dem der Schritt 3 durch Ionenstrahlsputtern bei einer Temperatur von ungefähr 50 °C realisiert wird.

12. Verfahren nach einem der Ansprüche 9 bis 11, das außerdem vor dem Entfernen der Ätzsperrschicht einen Schritt zur Kontrolle der Ätzung der Absorptionsschicht umfasst.

13. Verfahren nach Anspruch 12, bei dem die Kontrolle mit Hilfe einer Strahlung erfolgt, deren Wellenlänge zu dem Bereich gehört, der vom VIS- oder sichtbaren Bereich zum DUV- oder tiefultravioletten Bereich geht.

14. Verfahren nach einem der Ansprüche 9 bis 13, bei dem man eine zusätzliche bzw. komplementäre Ätzung der Absorptionsschicht durchführt, um eine gute Ätzung der Absorptionsschicht ohne Beschädigung der durch die Wechselfolge der reflektierenden Schichten gebildeten reflektierenden Multischicht zu ermöglichen, wobei diese reflektierende Multischicht durch die Ätzsperrschicht geschützt wird.

15. Verfahren nach Anspruch 14, bei dem die zusätzliche bzw. komplementäre Ätzung lokalisiert ist.
